# EUROPEAN PATENT SPECIFICATION

(11) **EP 1 181 800 B1**
(45) Date of publication and mention of the grant of the patent: **19.04.2006**
(21) Application number: 00935770.8
(22) Date of filing: 03.05.2000
(51) Int. Cl.: H04M 1/03

(54) **A TRANSMITTER/RECEIVER WITH A HOUSING AND A METHOD OF ITS ASSEMBLY**
EIN SENDER-EMPFÄNGER MIT GEHÄUSE UND EIN ZUSAMMENBAUVERFAHREN FÜR DENSELBEN
EMETTEUR/RECEPTEUR AVEC UN BOITIER ET PROCEDE D'ASSEMBLAGE CORRESPONDANT

(30) Priority: 12.05.1999 SE 9901756
(43) Date of publication of application: 27.02.2002
(73) Proprietor: TELEFONAKTIEBOLAGET LM ERICSSON (publ), 164 83 Stockholm (SE)
(72) Inventor: ENGBLOM, Göran, S-291 51 Kristianstad (SE)
(74) Representative: Platt, Timothy Nathaniel
(86) International application number: PCT/SE2000/000851
(87) International publication number: WO 2000/070843

(56) References cited:
- EP-A2- 0 762 708
- GB-A- 2 064 264
- US-A- 4 773 091
- US-A- 5 282 245
- US-A- 5 682 418

## Description

### BACKGROUND OF THE INVENTION

The present invention relates to a transmitter/receiver comprising a housing, said housing including a main body having a portion defining a rear sound inlet, and a front cover having a portion defining a front sound inlet, and further a microphone provided with a microphone housing having a front portion defining at least one front opening to be acoustically associated with said front sound inlet and a rear portion defining rear openings to be acoustically associated with said rear sound inlet.

Such a housing for a transmitter/receiver and such a transmitter/receiver is known from US-A-5 282 245. The known housing however suffers from a drawback in that the design thereof does not allow automatic assembly, i.e. it is not adapted for serial production, as e.g. the microphone cannot be mounted in the housing without difficulties. The therein described transmitter/receiver is rather a product, which is intended for extremely short series made by hand.

Another transmitter suffering from the corresponding drawback is known from US-A-5 682 418.

The object of the present invention is therefore to improve the known transmitter/receiver such that a series production is allowed.

### SUMMARY OF THE INVENTION

This object has been achieved by a transmitter/receiver as defined by claim 1 Hereby is achieved a fast mounting of the front cover towards the main body, while the first sealing member is guided towards the front cover, accomplishing that the first sealing member seals off the microphone in relation to the rest of the housing at the same time as it keeps the microphone in the desired position.

It has also been achieved by the method as defined by claim 8, wherein said first sealing member is adapted to receive a microphone means and to keep it centrally and equidistantly in relation to said front sound inlet and a rear sound inlet.

Suitably, said first sealing member is adapted to seal off said microphone having a predetermined size and form. Hereby is achieved that different kinds of microphones are allowed to be used in the production.

Preferably, said guide means is provided with at least a first guide member, against which the first sealing member is adapted to seal, said first guide member protruding from said inner surface of the front cover. Hereby is achieved that the mounting of the front cover allows the spacing means to be guided to a predetermined location of the interior of said front cover.

In particular, said first sealing member is provided with a flange having an annular protrusion, said flange being adapted to face a peripheral portion of the front portion of said microphone, said annular protrusion being adapted to seal a substantially annular space between the housing of the microphone and the microphone receiving member.

Preferably, a printed circuit board means is arranged between the main body and the front cover.

Advantageously, a side of the flange of the first sealing member facing the circular-cylindrical portion is provided with an annular reinforcement member adapted to bear against the side of the printed circuit board, which is intended to face the main body. Hereby, a quick mounting of the spacing means is achieved before mounting of the front cover on the main body.

### DRAWING SUMMARY

In the following the invention will be described with reference to the accompanying drawings, in which
Figure 1a and 1b are a perspective views of a mobile telephone having a microphone end,
Figure 2 is a cross-section of the microphone end of the mobile telephone shown in figure 1,
Figures 3a and 3b are exploded views of the mobile telephone at the microphone end including a printed circuit board,
Figures 4a and 4b illustrate insertion of a spacing means in different views.

### DETAILED DESCRIPTION

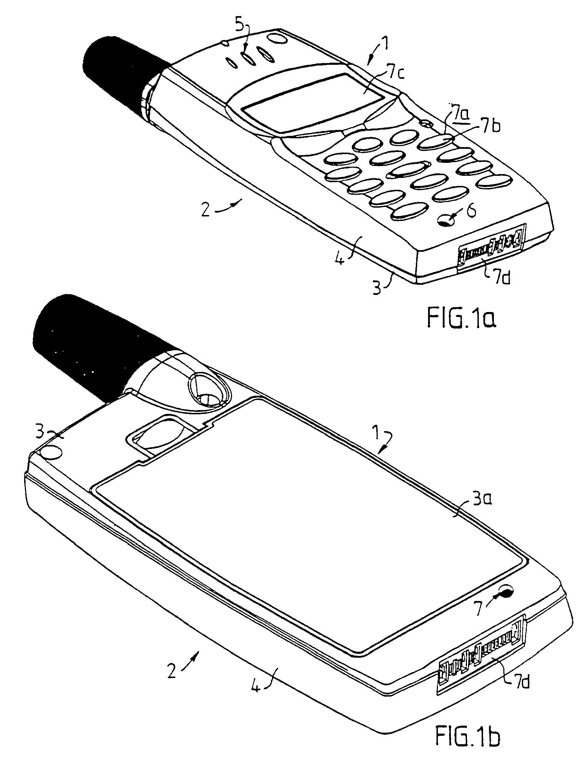

Figure 1a and 1b shows a mobile telephone 1, including a housing 2 including a main body 3 including a detachable or non-detachable, preferably rechargeable, battery 3 a and a front cover 4. The front cover 4 has a sound outlet 5, behind which, a loudspeaker is arranged. The front cover also has a front sound inlet 6, whereas the main body has a rear sound inlet 7. The front cover 4 is furthermore provided with openings 7a, in which push-buttons 7b are arranged, for allowing e.g. dialling of a telephone number or selecting a user option. A display 7c is provided for display of information and a system connector 7d for connection to external power supply and external microphone and loudspeaker, so called hands-free equipment.

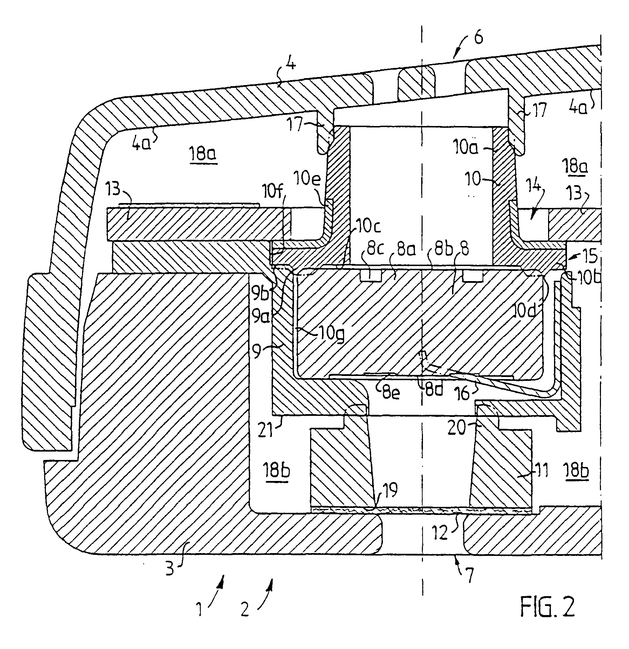

Figure 2 is a cross-section of a part of the mobile telephone, including the main body 3, front cover 4 having an inner surface 4a, the front sound inlet 6 and the rear sound inlet 7. Between the front and rear sound inlets, a circular cylindrical microphone 8 of the uni-directional kind is provided. The microphone 8 has a housing 8a including a front portion 8b defining at least one front sound opening 8c, which is directed towards the front sound inlet 6 of the front cover 4, and a rear portion 8d defining at least one rear sound opening 8e, which is directed towards the rear sound inlet 7 of the main body 3.

For achieving the best sound quality, a uni-directional or bi-directional microphone should be arranged centrally between the front sound inlet and the rear sound inlet. For this purpose, an circular cylindrical microphone member or seat 9 for a predetermined size of microphone 8 is provided. The seat 9 is furthermore an integral part of the system connector 7d. A front spacing means 10 is arranged between the microphone 8 and the front cover 4. Likewise, a rear spacing means 11 is provided between the seat 9 and the main body 3. The front spacing means 10 and the rear spacing means 11 also constitute sound sealing members, the purpose of which is to insulate against sound that has penetrated into the housing at other locations, e.g. at the push-buttons 7b. Accordingly, both the front and rear spacing means 10, 11 are at least partly constituted by a resilient, e.g. elastomeric, material.

Between the rear spacing means 11 and the main body 3, a sound damping member 12 covering the rear sound inlet 7 is provided for allowing less sound to penetrate to the microphone via the rear sound inlet 7, than via the front sound inlet 6.

The mobile telephone 1 is furthermore provided with a printed circuit board 13, hereinafter called PCB. The PCB 13 has a through-hole 14, through which a substantially circular cylindrical portion 10a of the front spacing means 10 extends, while an annular flange member 10b of a larger diameter than the through-hole 14 is intended to bear against the side of the PCB 13 which is intended to face the microphone 8. The flange 10b has an annular surface 10c, which is provided with an annular protrusion 10d, of a diameter slightly larger than the diameter of the microphone, however of a diameter slightly smaller than an annular edge 9a of the circular cylindrical seat 9. In order to achieve an even better contact, flange 10b is furthermore provided with an annular reinforcement member 10e, made of metal or hard plastics, which is intended to bear against the side of the PCB 13 facing the microphone in an annual groove 10f. This also causes the annular surface 10c to be pressed against the microphone and optionally against an annular surface 9b of the seat 9, whereas the annular protrusion 10d will be pressed into an annular space 10g between the microphone 8 and the seat 9. However, as shown in figure 2, a passage 15 for a microphone contact member 16 may be provided for allowing connection thereof to the PCB 13.

The front cover 4 is furthermore provided with an annular protrusion 17 of a diameter, which is slightly larger than the diameter of the circular cylindrical portion 10a of the front spacing means 10. When the front cover 4 is mounted on the main body 3, the portion 10a is pressed into the annular protrusion 17, as the portion 10a is constituted by an elastomeric material. A sound insulation between the front spacing means 10 and a space 18a between the PCB 13 and the front cover 4 is established.

The rear spacing means 11 has a flat rear surface 19 and an annular protrusion 20 intended to bear against a rear surface 21 of the seat 9. A sound insulation between the rear spacing means 11 and the space 18b between the PCB 13 and the main body 3 is thereby established.

It should be noted that in figure 2, the portions 10a, 10d and 20 have been shown in an uncompressed state for a better understanding of the figures.

When correctly mounted, the spacing means 10 and 11 ensure that the microphone 8 is mounted equidistantly, i.e. centrally between the openings 6, 7. They also insulate against sound that has penetrated through the housing 2 into the from the interior thereof so that the sound received by the microphone is substantially pure, i.e. substantially without sounds causing interfering noise. Also acoustic feedback from the loudspeaker is avoided. Furthermore, the spacing means 10 and 11 create an optimal sound path for a uni-directional microphone.

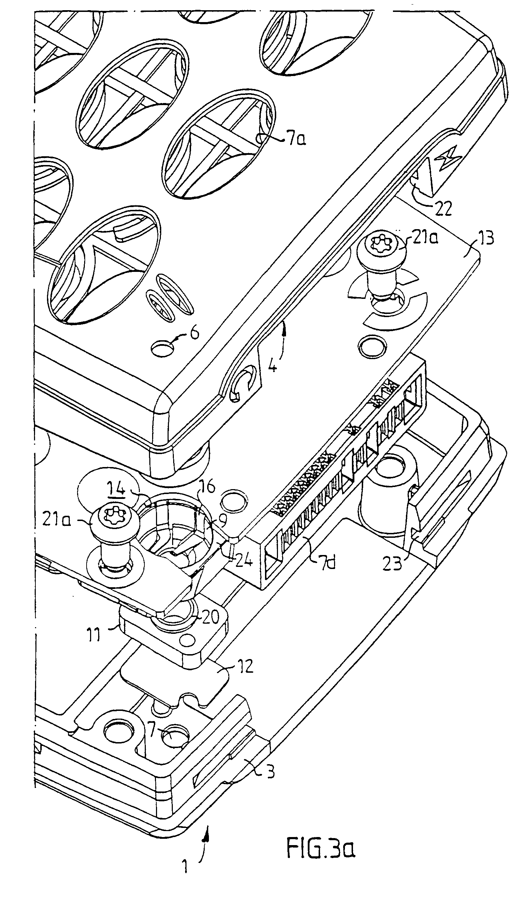

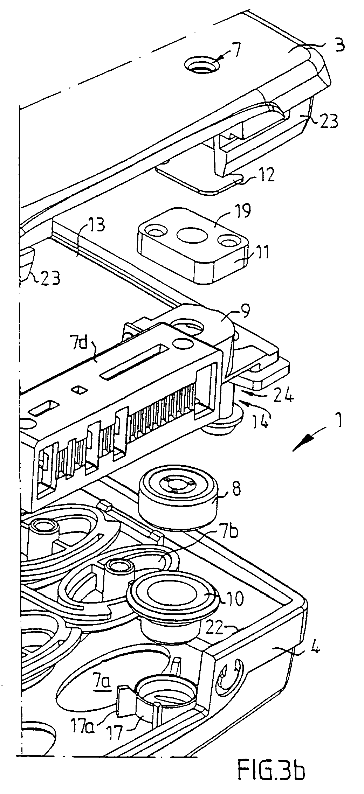

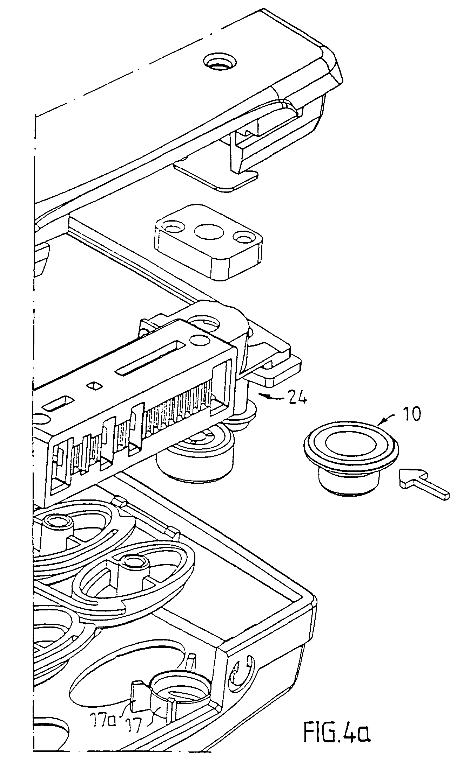

Figures 3a and 3b illustrate assembly of the mobile telephone 1 as seen from two different view angles. The PCB 13 is fastened to the main body 3 by means of screws 21a, thereby creating the above mentioned pressure on the rear spacing means 11. In turn, the front cover 4 is provided with a plurality of barb like protrusions 22, while the main body 3 is provided with thereto corresponding members 23, the protrusions 22 and members 23 together forming a snap lock. While mounting the front cover 4 on the main body 3, pressure is put on the front spacing means the front cover 4 on the main body 3, pressure is put on the front spacing means 10, so that a press-fit is created in relation to the annular protrusion 17. For facilitating mounting, the annular protrusion 17 is provided with a plurality of guide members 17a for guiding the circular cylindrical portion 10a of the front spacing means 10 towards the annular protrusion 17. It should be noted that each of the guide members 17a and the annular protrusion constitutes guide means for guiding the circular cylindrical portion 10a towards the inner surface 4a of the front cover 4.

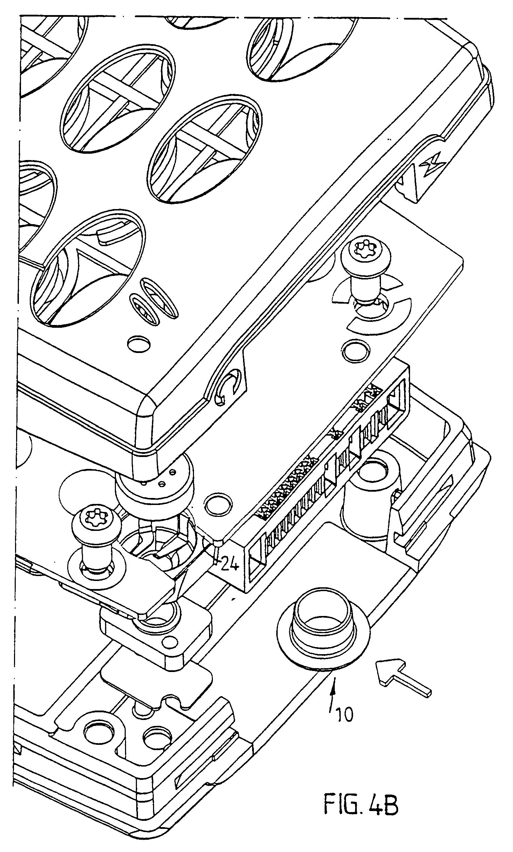

In order to facilitate quick assembly of the mobile telephone 1, the through-hole may be laterally opened to form a U-notch 14 with a side opening 24, which is large enough to allow the circular cylindrical portion 10a of the front spacing means 10 to pass laterally therethrough - indicated by arrows in Figures 4a and 4b - while sliding the flange 10b in the groove 10f between the PCB 13 and the seat 9.

### MOUNTING

When mounting the mobile telephone, the sound damping member 12 is put in place in front of the opening 7, see figures 2 and 3a. Thereafter the rear flat surface of the rear spacing means 11 is placed on the sound damping member 12. The system connector 7d with integrated seat 9 is then put in place, the annular protrusion 20 bearing against the a rear surface 21 of the seat 9. The microphone 8 is placed in the seat 9, whereafter the PCB 13 is placed on top of the system connector 7d and fastened to the main body 3 by means of the screws 21 a. Before tightening the screws 2 1 a completely, the flange 10b of the front spacing means 10 is slid into the groove 10f via the lateral opening 24. The circular cylindrical portion 10a protrudes through the U-notch 14. Thereafter, the screws 2 1 a are tightened, causing the annular protrusion to be deformed.

The front cover 4 is placed on top of the main body 3, and is fastened thereonto by means of the snap lock, i.e. the protrusions 22 and members 23, while gently pressing at the front sound inlet, the guide members 17a thereby guiding the circular cylindrical portion 10a of the front spacing means 10 towards the annular protrusion 17, which then is allowed to embrace the circular cylindrical portion 10a.

Of course, it would be possible to perform the assembly in such a way that the spacing means 10, 11, the seat 9 etc. are fastened onto the front cover by screwing the PCB 13 thereonto, whereafter the main body is snapped onto the front cover.

## Claims

1. A transmitter/receiver comprising a housing (2), said housing (2) including a main body (3) having a portion defining a rear sound inlet (7), and a front cover (4) having a portion defining a front sound inlet (6), and further a microphone (8) provided with a microphone housing (8a) having a front portion (8b) defining at least one front opening (8c) to be acoustically associated with said front sound inlet (6) and a rear portion defining rear openings (8e) to be acoustically associated with said rear sound inlet (7),
first and second sealing members (10, 11) being provided for sealingly keeping the microphone (8) substantially equidistant in a space (18a, 18b) between said front sound inlet (6) and said rear sound inlet (7), said first sealing member (10) being arranged in said space between said front sound inlet (6) and said microphone (8), wherein the front cover (4) being provided with a guide means (17, 17a) for guiding said first sealing member (10) towards an inner surface (4a) of said front cover, **characterised in that** in said space between the main body (3) and the front cover (4), there is arranged a printed circuit board means (13) having a U-notch (14) with an opening (24) adapted to laterally receive a circular-cylindrical portion (10a) of said first sealing member (10).

2. A transmitter/receiver according to claim 1, wherein said first sealing member (10) is adapted to seal off said microphone (8) having a predetermined size and form.

3. A transmitter/receiver according to claim 2, wherein said guide means (17, 17a) is provided with at least one first guide member (17), against which the first sealing member (10) is adapted to seal, said first guide member (17) protruding from said inner surface (4a) of the front cover (4).

4. A transmitter/receiver according to claim 3, wherein said first sealing member (10) is provided with a flange (10b) having an annular protrusion (10d), said flange being adapted to face a peripheral portion of the front portion (8b) of said microphone (8), said annular protrusion (10d) being adapted to seal a substantially annular space (10g) between the housing (8a) of the microphone and a microphone receiving member (9).

5. A transmitter/receiver according to Claim 4, wherein the surface of the flange (10b) of the first sealing member (10) facing the circuit board means (13) is provided with an annular reinforcement member (10) adapted to bear against a side of the printed circuit board (13).

6. A transmitter/receiver according to anyone of the preceding claims, wherein it is a mobile telephone (1), or a cordless telephone, a satellite telephone or a walkie-talkie, having a disconnectible or integrated power source (3a), such as a battery.

7. A transmitter/receiver according to anyone of the claims 1-5, wherein it is a stationary telephone.

8. A method of assembling a transmitter/receiver having a housing (2) with a main body (3) that has a rear sound inlet (7) and a front cover (4) that has a front sound inlet (6), including the following steps:
a) mounting a printed circuit board means (13) on the main body (3) of said housing (2);
b) laterally moving a circular-cylindrical portion (10a) of a first sealing member (10) through an opening (24) of a U-notch (14) in said printed circuit board means (13), while a flange (10b) of the first sealing member (10) facing the circular-cylindrical portion (10a) is adapted to lie against the side of the printed circuit board means (13),that faces the main body (3); wherein said first sealing member (10) and a second sealing member (11) are adapted to receive a microphone means (8) and to keep it centrally and equidistantly in relation to said front sound inlet (6) and said rear sound inlet (7).

9. A method according to claim 8, including providing said flange (10b) with an annular reinforcement member adapted to bear against the side of the printed circuit board (13) that faces the main body (3).

## Revendications

1. Emetteur/récepteur comprenant un boîtier (2), ledit boîtier (2) comprenant un corps principal (3) ayant une partie définissant une entrée arrière (7) de sons, et un capot avant (4) ayant une partie définissant une entrée avant (6) de sons, et en outre un microphone (8) pourvu d'un boîtier (8a) de microphone ayant une partie avant (8b) définissant au moins une ouverture avant (8c) destinée à être associée acoustiquement à ladite entrée avant (6) de sons et une partie arrière définissant des ouvertures arrières (8e) destinées être associées acoustiquement à ladite entrée arrière (7) de sons,
des premier et second éléments d'étanchéité (10, 11) étant prévus pour maintenir de façon étanche le microphone (8) d'une manière sensiblement équidistante dans un espace (18a, 18b) entre ladite entrée avant (6) de sons et ladite entrée arrière (7) de sons, ledit premier élément d'étanchéité (10) étant agencé dans ledit espace entre ladite entrée avant (6) de sons et ledit microphone, le capot avant (4) étant pourvu d'un moyen de guidage (17, 17a) destiné à guider ledit premier élément d'etanchéité (10) vers une surface intérieure (4a) dudit capot avant, **caractérisé en ce que**, dans ledit espace entre le corps principal (3) et le capot avant (4), est agencé un moyen (13) à plaquette à circuit imprimé ayant une encoche (14) en U avec une ouverture (24) conçue pour recevoir latéralement une partie cylindrique circulaire (10a) dudit premier élément d'étanchéité (10).

2. Emetteur/récepteur selon la revendication 1, dans lequel ledit premier élément d'étanchéité (10) est conçu pour assurer l'étanchéité dudit microphone (8) ayant une taille et une forme prédéterminées.

3. Emetteur/récepteur selon la revendication 2, dans lequel ledit moyen de guidage (17, 17a) est pourvu d'au moins un premier élément de guidage (17), contre lequel le premier élément d'etanchéité (10) est conçu pour assurer l'étanchéité, ledit premier élément de guidage (17) faisant saillie de ladite surface intérieure (4a) du capot avant (4).

4. Emetteur/récepteur selon la revendication 3, dans lequel ledit premier élément d'étanchéité (10) est pourvu d'un rebord (10b) ayant une saillie annulaire (10d), ledit record étant conçu pour faire face à une partie périphérique de la partie avant (8b) dudit microphone (8), ladite saillie annulaire (10d) étant conçue pour assurer l'étanchéité d'un espace sensiblement annulaire (10g) entre le boîtier (8a) du microphone et un élément (9) de réception du microphone.

5. Emetteur/récepteur selon la revendication 4, dans lequel la surface du rebord (10b) du premier élément (10) d'étanchéité faisant face au moyen (13) à plaquette à circuit est pourvue d'un élément annulaire (10) de renfort conçu pour porter contre un côté de la plaquette (13) à circuit imprimé.

6. Emetteur/récepteur selon l'une quelconque des revendications précédentes, dans lequel il s'agit d'un téléphone mobile (1), ou d'un téléphone sans fil, d'un téléphone par satellite ou d'un talkie-walkie, ayant une source d'énergie (3a) pouvant être déconnectée, ou intégrée, telle qu'une batterie.

7. Emetteur/récepteur selon l'une quelconque des revendications 1 à 5, dans lequel il s'agit d'un téléphone fixe.

8. Procédé d'assemblage d'un émetteur/récepteur ayant un boîtier (2) comprenant un corps principal (3) qui a une entrée arrière (7) de sons et un capot avant (4) qui a une entrée avant (6) de sons, comprenant les étapes suivantes qui consistent :
(a) à monter un moyen (13) à plaquette à circuit imprimé sur le corps principal (3) du boîtier (2) ;
(b) à déplacer latéralement une partie cylindrique circulaire (10a) d'un premier élement d'étanchéité (10) à travers une ouverture (24) d'une encoche (14) en U dans ledit moyen (13) à plaquette à circuit imprimé, tandis qu'un rebord (10b) du premier élément d'étanchéité (10) faisant face à la partie cylindrique circulaire (10a) est conçu pour s'appliquer contre le côté du moyen (13) à plaquette à circuit imprimé, qui fait face au corps principal (3) ; dans lequel ledit premier élément (10) d'étanchéité et un second élément (11) d'étanchéité sont conçus pour recevoir un moyen à microphone (8) et pour le maintenir centralement et à équidistance par rapport à ladite entrée avant (6) de sons et à ladite entrée arrière (7) de sons.

9. Procédé selon la revendication 8, comprenant le fait de pourvoir ledit rebord (10b) d'un élément annulaire de renfort conçu pour porter contre le côté de la plaquette (13) à circuit imprimé qui fait face au corps principal (3).

## Patentansprüche

1. Sender/Empfänger, umfassend ein Gehäuse (2), wobei dieses Gehäuse (2) einen Hauptkörper (3) beinhaltet, der einen Abschnitt aufweist, der einen rückwärtigen Schall-Einlass (7) definiert, sowie eine Front-Abdeckung (4), die einen Abschnitt aufweist, der einen vorderen Schall-Einlass (6) definiert, sowie des Weiteren ein Mikrophon (8), das mit einem Mikrophon-Gehäuse (8a) versehen ist, welches einen Front-Abschnitt (8b) aufweist, der zumindest eine FrontÖffnung (8c) definiert, um akustisch mit dem Front-Schall-Einlass (6) verbunden zu sein, sowie einen rückwärtigen Abschnitt, der rückwärtige öffnungen (8e) definiert, um akustisch mit dem rückwärtigen Schall-Einlass (7) verbunden zu sein,
wobei erste und zweite Abdichtelemente (10, 11) zum abgedichteten Halten des Mikrophons (8) im Wesentlichen in gleichem Abstand in einem Raum (18a, 18b) zwischen dem Front-Schall-Einlass (6) und dem rückwärtigen Schall-Einlass (7) vorgesehen ist, wobei das erste Abdichtelement (10) in diesem Raum zwischen dem Front-Schall-Einlass (6) und dem Mikrophon angeordnet ist, wobei die Front-Abdeckung (4) mit einem Führungselement (17, 17a) zum Führen des ersten Abdichelements (10) auf die innere Oberfläche (4a) der Front-Abdeckung hin vorgesehen ist, **dadurch gekennzeichnet, dass** in dem Raum zwischen dem Hauptkörper (3) und der Front-Abdeckung (4) ein Schaltkreis-Element (13) angeordnet ist, welches eine U-Kerbung (14) mit einer Öffnung (24) aufweist, die dazu geeignet ist, einen kreiszylindrischen Abschnitt (10a) des ersten Abdichtelements (10) seitlich aufzunehmen.

2. Sender/Empfanger gemäß Anspruch 1, wobei das erste Abdichtelement (10) dazu geeignet ist das Mikrophon (8), welches eine vorab bestimmte Größe und Form aufweist, abzudichten.

3. Sender/Empfänger gemäß Anspruch 2, wobei das Führungselement (17, 17a) mit zumindest einem ersten Führungsmittel (17) versehen ist, gegen dass das erste Abdichtelement (10) zur Abdichtung angepasst ist, wobei das erste Führungsmittel (17) von der inneren Oberfläche (4a) der Front-Abdeckung (4) hervorsteht.

4. Sender/Empfänger gemäß Anspruch 3, wobei das erste Abdichtelement (10) mit einem Flansch (10b) versehen ist, der einen ringförmigen Vorsprung (10d) aufweist, wobei der Flansch dazu geeignet ist, einem umfänglichen Abschnitt des Front-Abschnitt (8b) des Mikrophons (8) gegenüber zu stehen, und wobei der ringförmige Vorsprung (10d) dazu geeignet ist, einem im Wesentlichen ringförmigen Raum (10g) zwischen dem Gehäuse (8a) des Mikrophons und einem Mikrophon. Aufnahmeelement (9) abzudichten.

5. Sender/Empfänger gemäß Anspruch 4, wobei die Oberfläche des Flanschs (10b) des ersten Abdichtelements (10), das dem Schaltkreis-Element (13) gegenübersteht, mit einem ringförmigen Verstärkungselement (10) versehen ist, das dazu geeignet ist, eine Seite des Scheitkreises (13) zu lagere.

6. Sender/Empfänger gemäß einem der voranstehenden Ansprache, wobei dieser ein Mobiltelefon (1) oder ein schnurloses Telefon, ein Satellitentelefon oder ein Walkie-Talkie ist, welches eine entfernbare oder integrierte Energiequelle (3a) so wie eine Batterie aufweist.

7. Sender/Empfänger gemäß einem der Ansprüche 1 bis 5, wobei dieser ein stationares Telefon ist,

8. Verfahren zum Zusammebau eines Senders/Empfangers, der ein Gehäuse (2) mit einem Hauptkörper (3) aufweist der einen rückwartigen Schall-Einlass (7) sowie eine Front-Abdeckung (4) aufweist, die einen Pront-Schall-Einlass (6) aufweist, beinhaltend die folgenden Schritte:
a) Befestingen eines Schaltkreis-Elements (13) an dem Hauptkörper (3) des Gehäuses (2);
b) seitliches Bewegen eines kreiszylindrischen Abschnitts (10a) eines ersten Abdichtelements (10) durch eine Öffnung (24) einer U-Kerbung (14) in dem Schaltkreis-Element (13), während ein Flansch (10b) des ersten Äbdichtelements; (10), das dem kreiszylindrischen Abschnitt (10a) gegenübersteht, dazu geeignet ist, sich gegen, die Seite des Schaltkreis- Elements (13) anzulegen, welche dem Hauptkörpen (3) gegenübersteht, wobei das erste Abdchtelment (10) und ein zweites Abdichtelement (11) dazu geeignet sind, ein Mikrophon-Element (8) aufzunehmen und dieses zentral und im gleichen Abstand in Bezug auf den Front-Schall- Einlass (6) und den rückwärtigen Schall- Einlass (7) zu halten.

9. Verfahren gemäß Anspruch 8, beinhaltend das Bereitstellen des Flanschs (10b) mit einem ringförmigen Verstärkungselement, das dazu geeignet ist, die Seite des Schaltkreises (13), die dem Hauptkörper (3) gegenübersteht, zu lagern.
